# EUROPÄISCHE PATENTSCHRIFT

(11) **EP 2 068 404 B1**
(45) Veröffentlichungstag und Bekanntmachung des Hinweises auf die Patenterteilung: **05.11.2014**
(21) Anmeldenummer: 08105791.1
(22) Anmeldetag: 13.11.2008
(51) Int. Cl.: H01R 13/641, H01R 13/41, H01R 31/08, H05K 5/02

(54) **Deckel mit Stecker für eine Deckel-Offen-Erkennung**
Cover with plug for identification of open cover
Couverture avec prise pour l'identification de la couverture ouverte

(30) Priorität: 05.12.2007 DE 202007016957 U
(43) Veröffentlichungstag der Anmeldung: 10.06.2009
(73) Patentinhaber: ROBERT BOSCH GMBH, 70442 Stuttgart (DE)
(72) Erfinder: Stoeckl, Rainer, 71701, Schwieberdingen (DE); Hoebel, Ralf, 75417, Muehlacker (DE)

(56) Entgegenhaltungen:
- DE-A1- 19 848 554
- DE-A1- 19 913 146
- JP-A- 2002 352 926
- US-A- 4 430 524

## Beschreibung

### Stand der Technik

Die Erfindung geht aus von einem Deckel zur Befestigung an einem Gehäuseteil nach der Gattung des Patentanspruchs 1.

Ein solcher Deckel ist beispielsweise durch die DE 199 13 146 A1 bekannt geworden. An diesem bekannten Deckel ist auf nicht näher beschriebene Weise ein Stecker festgelegt, der mit einem Gegenstecker des Gehäuses zusammenwirkt. Üblicherweise werden Stecker, insbesondere Stecker für eine Deckel-Offen-Erkennung, durch Standardverbindungselemente (z.B. Schrauben) am Deckel befestigt.
JP 2002 352 926 zeigt ein Gehäuseteil gemäß dem Oberbegriff des Anspruchs 1.

### Offenbarung der Erfindung

Erfindungsgemäß wird vorgeschlagen, den in eine Aufnahme des Gehäuseteils eingesteckten Stecker darin durch plastische Verformung des Rands der Aufnahme zu positionieren und unverlierbar zu fixieren. Diese unverlierbare Verbindung stellt eine kostengünstige Lösung dar und ermöglicht hohe Abzugskräfte

Weitere Vorteile und vorteilhafte Ausgestaltungen des Gegenstands der Erfindung sind der Beschreibung, der Zeichnung und den Ansprüchen entnehmbar.

### Kurze Beschreibung der Zeichnung

Ein Ausführungsbeispiel des erfindungsgemäßen Gehäuseteils ist in der Zeichnung dargestellt und in der nachfolgenden Beschreibung näher erläutert. Die in den Figuren gezeigten Merkmale sind rein schematisch und nicht maßstäblich zu verstehen. Es zeigt:
- Fig. 1: die Unterseite eines als Deckel ausgeführten erfindungsgemäßen Gehäuseteils mit einem daran befestigten elektrischen Stecker für eine Deckel-offen-Erkennung, und
- Fig. 2: einen Längsschnitt des Deckels gemäß II-II in Fig. 1.

### Ausführungsform der Erfindung

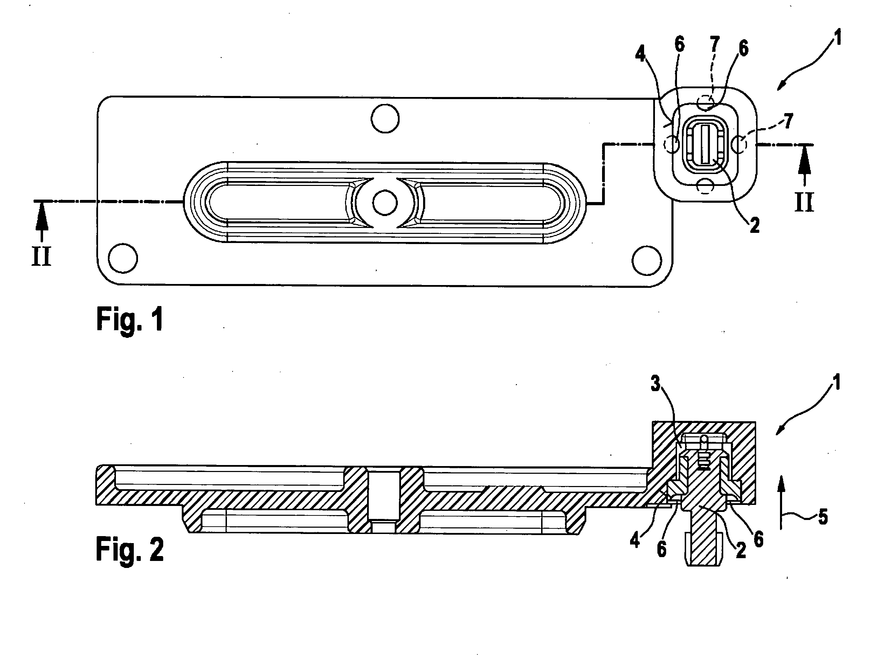

Der in **Fign. 1 und 2** gezeigte Deckel **1** aus Kunststoff dient zum Verschließen einer Gehäuseöffnung eines Gehäuses (nicht gezeigt). Für eine Deckel-Offen-Erkennung ist am Gehäusedeckel 1 innenseitig ein elektrischer Stecker **2** befestigt, der nur dann, wenn der Deckel 1 die Gehäuseöffnung verschließt, einen elektrischen Gegenstecker des Gehäuses kontaktiert und einen Überwachungsstromkreis schließt. Auf diese Weise wird ein offener Deckel bzw. eine nicht verschlossene Gehäuseöffnung erkannt.

Der Stecker 2 ist in eine Aufnahme **3** des Deckels 1 eingesteckt und darin durch den plastisch verformten Rand **4** der Aufnahme 3, der den Stecker 2 entgegen seiner Einsteckrichtung **5** übergreift, gehalten. Der Rand 4 der Aufnahme 3 weist vier plastisch verformte Verstemmnasen **6** auf, die den Stecker 2 entgegen seiner Einsteckrichtung 5 übergreifen und so im Deckel 1 positionieren und unverlierbar fixieren. Die Verstemmnasen 6 sind im Winkelabstand von jeweils 90° vorgesehen und liegen jeweils paarweise einander bezüglich der Aufnahme 3 gegenüber.

Genauer gesagt wird, wenn der Stecker 2 in die Aufnahme 3 eingesteckt ist, mit einem vierarmigen Stempel auf den Rand 4 der Aufnahme 3 gedrückt, bis durch Verstemmen bzw. plastisches Verformen von Gehäusematerial radial in die Aufnahme 3 hinein die Verstemmnasen 6 ausgebildet sind. Das Drücken des Stempels kann weg- oder kraftgesteuert erfolgen. Die Stempelabdrücke (d.h. Vertiefungen) im Deckel 1 sind in Fig. 1 gestrichelt dargestellt und mit **7** bezeichnet.

## Patentansprüche

1. Gehäuseteil (1), insbesondere Deckel, zur Befestigung an einem anderen Gehäuseteil, mit einem am Gehäuseteil (1) befestigten elektrischen Stecker (2) zum Kontaktieren eines elektrischen Gegensteckers am anderen Gehäuseteil, wobei
der Stecker (2) in eine Aufnahme (3) des Gehäuseteils (1) eingesteckt ist und **dadurch gekennzeichnet, dass** im in die Aufnahme (3) eingesteckten Zustand durch plastische Verformung des Randes der Aufnahme vom plastisch verformten Gehäusematerial entgegen seiner Einsteckrichtung (5) übergriffen ist und derart in der Aufnahme (3) gehalten ist.

2. Gehäuseteil nach Anspruch 1, **dadurch gekennzeichnet, dass** der Rand (4) der Aufnahme (3) mindestens eine plastisch verformte Verstemmnase (6) aufweist, die den Stecker (2) entgegen seiner Einsteckrichtung (5) übergreift.

3. Gehäuseteil nach Anspruch 2, **dadurch gekennzeichnet, dass** der Rand (4) der Aufnahme (3) mindestens zwei Verstemmnasen (6) aufweist, die den Stecker (2) entgegen seiner Einsteckrichtung (5) übergreifen.

4. Gehäuseteil nach Anspruch 3, **dadurch gekennzeichnet, dass** die mindestens zwei Verstemmnasen (6) bezüglich der Aufnahme (3) einander gegenüberliegen.

5. Gehäuseteil nach Anspruch 3 oder 4, **dadurch gekennzeichnet, dass** die Verstemmnasen (6) jeweils in gleichem Winkelabstand zueinander vorgesehen sind.

6. Gehäuseteil nach einem der vorhergehenden Ansprüche, **dadurch gekennzeichnet, dass** das Gehäuseteil (1) aus Kunststoff gebildet ist.

## Claims

1. Housing part (1), in particular cover, which is to be fastened to another housing part, having an electrical plug (2), which is fastened to the housing part (1), for making contact with a mating electrical plug on the other housing part, wherein the plug (2) is inserted into a receptacle (3) in the housing part (1), and **characterized in that**, in the state in which the said plug is inserted into the receptacle (3), as a result of plastic deformation of the edge of the receptacle, the plastically deformed housing material engages over the plug counter to its insertion direction (5), and the said plug is held in the receptacle (3) in this way.

2. Housing part according to Claim 1, **characterized in that** the edge (4) of the receptacle (3) has at least one plastically deformed caulking tab (6) which engages over the plug (2) counter to its insertion direction (5).

3. Housing part according to Claim 2, **characterized in that** the edge (4) of the receptacle (3) has at least two caulking tabs (6) which engage over the plug (2) counter to its insertion direction (5).

4. Housing part according to Claim 3, **characterized in that** the at least two caulking tabs (6) are situated opposite one another with respect to the receptacle (3).

5. Housing part according to Claim 3 or 4, **characterized in that** the caulking tabs (6) are provided at the same angular distance in relation to one another in each case.

6. Housing part according to one of the preceding claims, **characterized in that** the housing part (1) is formed from plastic.

## Revendications

1. Partie de boîtier (1), en particulier couvercle, pour la fixation à une autre partie de boîtier, comprenant un connecteur électrique (2) fixé à la partie de boîtier (1) pour le contact d'un connecteur électrique conjugué sur l'autre partie de boîtier,
le connecteur (2) étant enfiché dans un logement (3) de la partie de boîtier (1) et **caractérisée en ce que** le connecteur, dans l'état enfiché dans le logement (3), par déformation plastique du bord du logement, est saisi par le dessus par le matériau de boîtier déformé plastiquement à l'encontre de sa direction d'enfichage (5) et est retenu ainsi dans le logement (3).

2. Partie de boîtier selon la revendication 1, **caractérisée en ce que** le bord (4) du logement (3) présente au moins un nez de matage (6) déformé plastiquement qui vient en prise par le dessus avec le connecteur (2) à l'encontre de sa direction d'enfichage (5).

3. Partie de boîtier selon la revendication 2, **caractérisée en ce que** le bord (4) du logement (3) présente au moins deux nez de matage (6) qui viennent en prise par le dessus avec le connecteur (2) à l'encontre de sa direction d'enfichage (5).

4. Partie de boîtier selon la revendication 3, **caractérisée en ce que** les au moins deux nez de matage (6) sont opposés l'un à l'autre par rapport au logement (3).

5. Partie de boîtier selon la revendication 3 ou 4, **caractérisée en ce que** les nez de matage (6) sont à chaque fois prévus avec le même espacement angulaire l'un par rapport à l'autre.

6. Partie de boîtier selon l'une quelconque des revendications précédentes, **caractérisée en ce que** la partie de boîtier (1) est formée de plastique.
